# FASCICULE DE BREVET EUROPEEN

(11) **EP 1 882 954 B1**
(45) Date de publication et mention de la délivrance du brevet: **08.06.2016**
(21) Numéro de dépôt: 07290905.4
(22) Date de dépôt: 19.07.2007
(51) Int. Cl.: G01R 15/22, G01R 15/14, G08C 23/04

(54) **Dispositif de mesure de l'énergie électrique fournie à un engin de traction ferroviaire**
Vorrichtung zur Messung der an eine Eisenbahnlokomotive gelieferten elektrischen Energie
Device for measuring the electrical energy provided to a railway traction engine

(30) Priorité: 25.07.2006 FR 0606797
(43) Date de publication de la demande: 30.01.2008
(73) Titulaire: ALSTOM Transport Technologies, 93400 Saint-Ouen (FR); MS Relais, 93118 Rosny sous Bois (FR)
(72) Inventeur: Arrouy, Jean-Marie, 65460 Bours (FR); Couget, Maurice, 65190 Lanespede (FR); Dosda, Olivier, 72300 Notre Dame du Pe (FR); Lejeune, Claude, 72200 La Fleche (FR)
(74) Mandataire: Blot, Philippe Robert Emile

(56) Documents cités:
- EP-A- 0 743 528
- WO-A-2004/072662
- DE-A1- 10 005 164
- DE-A1- 19 543 363
- DE-A1-102004 042 101
- FR-A- 2 698 695
- FR-A- 2 865 973
- GB-A- 2 400 172
- US-A- 5 585 611
- TREIGE P ET AL: "Energiemessung auf elektischen Triebfahrzeugen bei der Deutschen Bahn./On-board energy measurment at electric motor vehicles of Deutsche Bahn./", ELEKTRISCHE BAHNEN, OLDENBOURG INDUSTRIEVERLAG, MUNCHEN, DE, vol. 98, no. 8, 1 August 2000 (2000-08-01) , pages 300-305, XP008083735, ISSN: 0013-5437

## Description

La présente invention concerne un dispositif de mesure de l'énergie électrique fournie - sous haute tension - à une locomotive ou plus généralement au moteur d'un véhicule de chemin de fer.

### ARRIERE PLAN DE L'INVENTION

Comme présenté dans le document Treigle et al., « Energiemessung auf elektrischen Triebfahrzeugen bei der Deutschen Bahn », Elektrische Bahnen vol. 98, no. 8 (2000), pages 300 - 305, l'énergie électrique fournie notamment par la caténaire à une locomotive demande à être mesurée pour en réaliser la facturation aux consommateurs par le fournisseur. Ce besoin est relativement nouveau car il résulte des règles récentes imposant une liberté d'exercice pour plusieurs opérateurs fournisseurs d'électricité sur un réseau et pour plusieurs opérateurs utilisateurs de cette énergie sur le même réseau.

La réalisation de cette mesure est dans son principe extrêmement simple : il faut relever l'intensité du courant consommé, sa tension et le temps de consommation, soit en continu soit par échantillonnage à une fréquence significative, pour prendre en compte les variations de ces deux paramètres au fil du temps.

En pratique, les choses sont plus compliquées par le fait que les appareils de mesure sont dans un environnement de réseau haute tension (de 1500 volts en courant continu à 25000 volts en courant alternatif selon les parties de réseau parcouru) pour ce qui concerne l'acquisition de la variable et dans un environnement basse tension pour ce qui concerne l'élaboration et le traitement du signal. L'isolation entre les deux environnements, appelé isolement galvanique, requiert donc un soin et un sérieux particuliers.

Les moyens connuspour assurer cette isolation galvanique sont généralement mis en oeuvre au niveau des transformateurs que les appareils de mesure comportent, l'isolation requise demandant de mettre en oeuvre entre primaire et secondaire d'un tel transformateur des matériaux diélectriques de haute qualité et surtout dans un volume suffisant pour éloigner au maximum les pièces conductrices les unes des autres.

Ce volume et cette masse sont à prévoir au niveau du toit de l'engin moteur. Ils viennent s'ajouter à tous les équipements de toiture de cet engin de traction ce qui, dans le meilleur des cas, constitue une augmentation du maître couple de ces équipements, donc une traînée gênante pour les trains à grande vitesse et, le plus souvent, est tout simplement impossible par manque de place dans cet espace particulièrement encombré.

Par ailleurs, il est connu, par le document DE-102004042101 A par exemple, un dispositif de transmission formant un isolateur de toiture entre des capteurs situés en toiture et une électronique de traitement. Ce dispositif, intègre une ligne de transmission de données constituée d'une fibre optique et d'une ligne de transmission de l'alimentation électrique constituée d'un transformateur ou d'un fibre optique.

Les documents WO 2004/072662 A et DE 195 43 363 A décrivent des systèmes pour la mesure d'une intensité de courant et/ou d'une tension sur une ligne haute tension par l'utilisation de fibres optiques pour la transmission des données mesurées par des moyens de mesure à une unité de traitement de données et pour la transmission d'énergie d'alimentation des moyens de mesure entre un niveau de basse tension et un niveau de haute tension.

### OBJET DE L'INVENTION

La présente invention est une solution à ce problème d'encombrement qui, sans sacrifier aux exigences d'isolément, autorise une miniaturisation des capteurs et appareils mis en oeuvre suffisante pour les loger sans encombre parmi le matériel de toiture d'un engin de traction ferroviaire.

### RESUME DE L'INVENTION

A cet effet, l'invention a donc pour objet un dispositif de mesure de l'énergie électrique fournie à un engin de traction ferroviaire par une ligne haute tension, comportant des moyens de mesure de l'intensité du courant d'alimentation et des moyens de mesure de la tension de cette alimentation, ces moyens de mesure possédant une source d'alimentation basse tension nécessaire à leur fonctionnement dans lequel l'énergie d'alimentation basse tension est une énergie optique convertie en une énergie électrique dans l'environnement haute tension. En outre, les signaux de sortie des moyens de mesure sont convertis en signaux optiques pour leur exploitation. Ainsi, on réalise un isolement galvanique extrêmement important entre l'étage haute tension des appareils de mesure et l'étage basse tension de ces derniers. La conversion d'une énergie électrique en énergie optique et la conversion inverse est réalisée au moyen d'appareils connus de petit encombrement qui permettent donc de loger le dispositif de mesure sous un faible volume et en particulier dans un isolateur de la ligne de toit haute tension de l'engin ferroviaire.

D'autres caractéristiques et avantages dé l'invention ressortiront de la description donnée ci-après d'un exemple de sa réalisation.

### BREVE DESCRIPTION DES DESSINS

Il sera fait référence aux dessins annexés parmi lesquels :
- la figure 1 est un schéma électrique d'un dispositif de mesure conforme à l'invention,
- la figure 2 est un schéma d'implantation de ce dispositif de mesure dans un isolateur de la ligne de toit haute tension de l'engin ferroviaire consommateur de l'énergie mesurée.

### DESCRIPTION DETAILLEE DE L'INVENTION

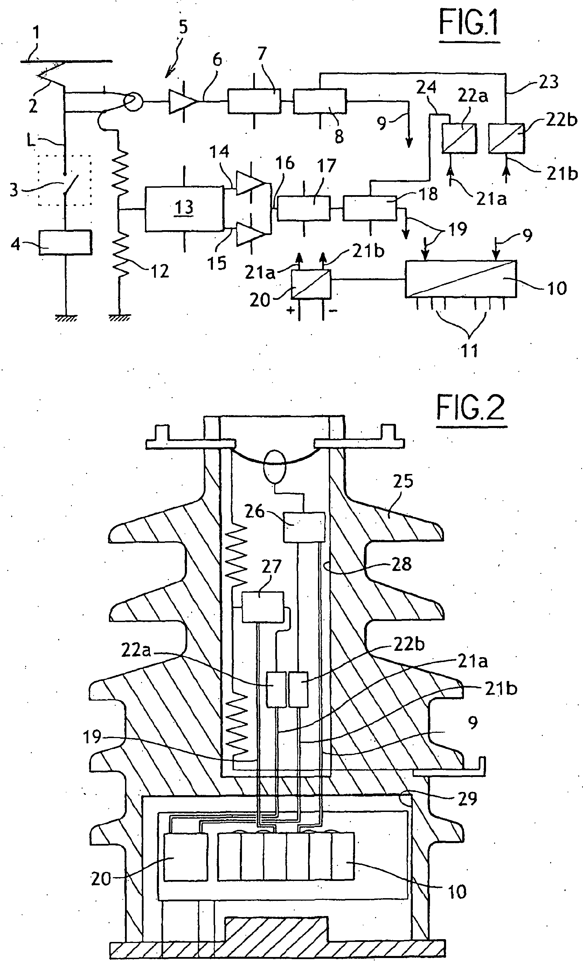

A la figure 1, 1 désigne la caténaire tandis que le pantographe du véhicule est représenté par la référence 2. La ligne de toit haute tension de l'engin ferroviaire est notée L en passant par un disjoncteur 3 pour parvenir à l'ensemble des moyens d'alimentation de la chaîne de traction 4.

En série sur cette ligne L, et de manière tout à fait connue, un capteur d'intensité 5, par exemple un shunt de mesure de courant, permet d'émettre sur sa sortie 6 un signal analogique converti en un signal numérique par un convertisseur 7 dont la sortie aboutit à un convertisseur électrique/optique 8 transformant le signal électrique numérique issu du convertisseur en un signal optique véhiculé par une fibre optique 9 en direction d'un convertisseur optique/électrique 10 possédant des sorties 11 destinées au raccordement de l'électronique d'exploitation de ce signal issu du transformateur d'intensité et représentatif de l'intensité du courant d'alimentation haute tension de l'engin.

Par un diviseur de tension 12, il est possible de recueillir au moyen d'un discriminateur 13 de tensions continue ou alternative, des signaux représentatifs de ces tensions. Par exemple, le signal présent à la sortie 14 du discriminateur 13 est significatif de la valeur de la tension alternative présente sur la caténaire 1.

La sortie 15 est réservée à un signal significatif d'une tension continue sur la caténaire 1.

L'un ou l'autre de ces signaux est conduit à l'entrée 16 d'un convertisseur 17 analogique numérique dont la sortie aboutit à l'entrée d'un convertisseur 18 électrique/optique. Le signal optique engendré par ce convertisseur est conduit par une fibre optique 19 à l'entrée du convertisseur 10 qui présentera en réponse sur certaines de ses sorties 11 un signal électrique destiné à être exploité par le dispositif en combinaison avec le signal électrique représentatif de la valeur de l'intensité du courant d'alimentation.

Certains des composants du dispositif ont besoin pour fonctionner d'une alimentation en énergie électrique, notamment les convertisseurs électriques/optiques ou optiques/électriques tels que ceux 10, 8 et 18. Pour ce qui concerne le convertisseur 10, celui-ci est alimenté directement par une batterie qui elle-même est connectée à un convertisseur 20 d'énergie électrique continue en une énergie optique, sous la forme d'un faisceau laser émis par un système lumineux tel qu'une diode. Le faisceau laser est conduit par des fibres optiques 21 a, 21 b en direction de convertisseurs optique/électrique 22a, 22b qui possèdent respectivement une sortie 24 d'alimentation du convertisseur électrique/optique 18 et une sortie 23 d'alimentation du convertisseur électrique/optique 8.

La figure 2 illustre la mise en place du circuit représenté à la figure 1 à l'intérieur d'un corps isolateur 25 et montre ainsi comment une parfaite isolation galvanique est assurée dans le dispositif de mesure selon l'invention. Sur cette figure on retrouve la plupart des éléments déjà décrits avec les mêmes références. Les éléments relatifs au traitement du signal du capteur d'intensité 5 sont regroupés schématiquement dans un bloc 26 alimenté en basse tension par la ligne 23 et présentant en sortie sur une fibre optique 9 le signal optique représentatif de l'intensité mesurée.

De la même manière, les moyens de traitement du signal de tension issus du diviseur 12 sont regroupés dans un bloc 27 auquel aboutit la ligne d'alimentation 24 et de laquelle est issue la fibre optique 19. On comprend donc au vu de cette figure que l'environnement haute tension est confiné dans un espace supérieur 28 ménagé dans l'isolateur 25, traversé par la ligne L de toit de l'engin ferroviaire tandis que l'environnement basse tension est confiné dans un évidement 29 inférieur de cet isolateur. Entre les deux évidements, seules des fibres optiques forment la liaison des différents composants du dispositif de l'invention.

Le dispositif de mesure selon l'invention peut également être utilisé comme moyen de reconnaissance du réseau (de la tension du courant délivré à l'engin de traction) qui peut-être de 1500 volts en courant continu, de 3500 volts en courant continu (généralement traité comme le précédent), de 15000 volts en courant alternatif à 16 Hz 1/3, de 25000 volts en courant alternatif à 50 Hz ou à 60 Hz, de 12.000 volts alternatif à 60 Hz et de 12.000 volts alternatif à 25 Hz pour ne citer que les cas de figures rencontrés dans les principaux pays industrialisés. En effet, le signal optique présent à la sortie de la fibre 19 est significatif d'une tension de mesure dont la valeur est elle-même en correspondance avec la tension du courant du réseau. Ainsi chacune des trois sorties 11 affectées à la tension peut, par un jeu de relais dans les moyens de conversion 10, être attribuée l'une des tensions que peut offrir le réseau. La présence du signal sur une seule des trois sorties 11 affectées à la tension permet de reconnaître la tension du réseau en train d'être parcouru par l'engin ferroviaire.

## Revendications

1. Dispositif de mesure de l'énergie électrique fournie à un engin de traction ferroviaire par une ligne de haute tension (1), le dispositif destiné à être placé sur une ligne de toit haute tension (L) reliant un pantographe et des moyens d'alimentation de la chaîne de traction, le dispositif comprenant des moyens de mesure de l'intensité du courant d'alimentation et des moyens de mesure de la tension d'alimentation,
- les moyens de mesure de l'intensité du courant d'alimentation comportant un capteur d'intensité (5) un premier convertisseur analogique / numérique (7) et un premier convertisseur électrique / optique (8), le premier convertisseur électrique/optique étant propre à transformer le signal électrique numérique issu du premier convertisseur analogique / numérique (7) en un signal optique véhiculé par une première fibre optique (9) en direction d'un troisième convertisseur optique / électrique (10) possédant des sorties (11) destinées au raccordement à une électronique d'exploitation ; et,
- les moyens de mesure de la tension d'alimentation comportant un diviseur de tension (12), un discriminateur (13) de tensions continue ou alternative, un second convertisseur analogique/numérique (17) et un second convertisseur électrique / optique (18), le second convertisseur électrique/optique étant propre à transformer le signal électrique numérique issu du second convertisseur analogique / numérique (17) en un signal optique conduit par une seconde fibre optique (19) à l'entrée du troisième convertisseur optique/électrique (10),
le dispositif comporte une batterie connectée à un troisième convertisseur électrique / optique (20), propre à générer un faisceau laser conduit par des troisièmes fibres optiques (21a, 21b) en direction de premier et second convertisseurs optique / électrique (22a, 22b), respectivement connectés au premier convertisseur électrique / optique (8) et au second convertisseur électrique / optique (18) pour leur alimentation électrique respective, le troisième convertisseur optique / électrique (10) étant alimenté directement par la batterie,
et le dispositif comporte un corps isolateur (25) comportant un évidement supérieur (28) de confinement de l'environnement haute tension, regroupant les moyens de mesure de l'intensité et de la tension d'alimentation et les premier et second convertisseurs optique / électronique (22a, 22b), et un évidement inférieur (29) de confinement de l'environnement basse tension, regroupant le troisième convertisseur électrique/optique (20) et le troisième convertisseur optique/électrique (10), seules les première, seconde et troisièmes fibres optiques reliant les évidements supérieur (28) et inférieur (29).

2. Dispositif selon la revendication 1, dans lequel la ligne de toit haute tension (L) traverse l'évidement supérieur (29) du corps isolateur (25).

3. Dispositif selon la revendication 1 ou la revendication 2, chacune des sorties (11) constitue un moyen de reconnaissance du réseau lorsqu'elle porte un signal.

## Patentansprüche

1. Vorrichtung zum Messen der elektrischen Energie, die einer Eisenbahnzugmaschine über eine Hochspannungsleitung (1) bereitgestellt wird, wobei die Vorrichtung dazu vorgesehen ist, auf einer Hochspannungsdachleitung (L) angeordnet zu werden, die einen Stromabnehmer und Stromversorgungsmittel der Antriebskette verbindet, wobei die Vorrichtung Mittel zum Messen der Stromversorgungsstromstärke und Mittel zum Messen der Stromversorgungsspannung aufweist,
- wobei die Mittel zum Messen der Stromversorgungsstromstärke einen Stärkesensor (5), einen ersten analog/digital-Wandler (7) und einen ersten elektrisch/optisch-Wandler (8) aufweisen, wobei der erste elektrisch/optisch-Wandler dazu geeignet ist, das von dem ersten analog/digital-Wandler (7) ausgegebene elektrische digitale Signal in ein optisches Signal umzuwandeln, das von einer ersten optischen Faser (9) in Richtung eines dritten optisch/elektrisch-Wandlers (10) transportiert wird, der Ausgänge (11) besitzt, die zum Anschluss an eine Auswertungselektronik vorgesehen sind; und
- wobei die Mittel zum Messen der Stromversorgungsspannung einen Spannungsteiler (12), einen Gleichspannungs- oder Wechselspannungs-Diskriminator (13), einen zweiten analog/digital-Wandler (17) und einen zweiten elektrisch/optisch-Wandler (18) aufweisen, wobei der zweite elektrisch/optisch-Wandler geeignet ist, das von dem zweiten analog/digital-Wandler (17) ausgegebene elektrische digitale Signal in ein optisches Signal umzuwandeln, das von einer zweiten optischen Faser (19) an den Eingang des dritten optisch/elektrische-Wandlers (10) geleitet wird,
wobei die Vorrichtung eine Batterie aufweist, die mit einem dritten elektrisch/optisch-Wandler (10) verbunden ist, der geeignet ist, einen Laserstrahl zu erzeugen, der von dritten optischen Fasern (21a, 21b) in Richtung des ersten und des zweiten optischen/elektrischen Wandlers (22a, 22b) geleitet wird, die mit dem ersten elektrisch/optisch-Wandler (8) bzw. mit dem zweiten elektrisch/optisch-Wandler (18) für ihre jeweilige elektrische Versorgung verbunden sind, wobei der dritten optisch/elektrische Wandler (10) direkt durch die Batterie versorgt wird,
und wobei die Vorrichtung einen Isolatorkörper (25) aufweist, der eine obere Aussparung (28) zum Begrenzen der Hochspannungsumgebung, die die Mittel zum Messen der Stromversorgungsstromstärke und der Stromversorgungsspannung und den ersten und den zweiten optisch/elektronisch-Wandler (22a, 22b) umfasst, und eine untere Aussparung (29) zum Begrenzen einer Niederspannungsumgebung aufweist, die den dritten elektrisch/optisch-Wandler (20) und den dritten optisch/elektrisch-Wandler (10) umfasst, wobei nur die erste, zweite und dritte optische Faser die obere Aussparung (28) und die untere Aussparung (29) verbinden.

2. Vorrichtung gemäß Anspruch 1, in dem die Hochspannungsdachleitung (L) die obere Aussparung (28) des Isolatorkörpers (25) durchläuft.

3. Vorrichtung gemäß Anspruch 1 oder Anspruch 2, wobei jeder der Ausgänge (11) ein Mittel zum Erkennen des Netzes, wenn er ein Signal trägt, aufweist.

## Claims

1. Apparatus for measuring the electrical energy supplied to a rail traction unit by a high voltage line (1), the apparatus being intended to be installed on the roof high voltage line (L) connecting the pantograph to power supply means of the traction unit, the apparatus comprising means for measuring the intensity of the power current and means for measuring the power voltage,
- The means for measuring the intensity of the power current comprising a current sensor (5), a first analog-to-digital converter (7) and a first electrical/optical converter (8), the first electrical/optical converter being capable of transforming the digital electric signal outputted by the first analog-to-digital converter (7) into an optical signal transmitted by a first optical fiber (9) toward a third optical / electrical converter (10) provided with outputs (11) to be connected to processing electronics; and,
- The means for measuring the power voltage comprising a voltage divider (12), a discriminator (13) to sense DC or AC voltages, a second analog-to-digital converter (17) and a second electrical/optical converter (18), the second electrical/optical converter being capable of transforming the digital electric signal outputted by the second analog-to-digital converter (17) into an optical signal transmitted by a second optical fiber (19) at the input of a third optical/electrical converter (10),
the apparatus comprising a battery connected to a third electrical/ optical converter (20), capable of generating a laser beam conveyed by third optical fibers (21a, 21b) to first and second optical/electrical converters (22a, 22b) respectively connected to the first electrical/optical converter (8) and the second electrical/optical converter (18) for their respective electric power supply, the third optical/electrical converter (10) being power supplied by the battery directly, and the apparatus comprises an insulator body (25) comprising a top space (28) for the confinement of the high voltage environment, regrouping the means for measuring the intensity of the power current, the means for measuring the power voltage, and the first and second optical/electrical converters (22a, 22b), and bottom recess (29) for the confinement of the low voltage environment, regrouping the third electrical/optical converter (20) and the third optical/electrical converter (10), only the first, second and third optical fibers providing a link between the top space (28) and the bottom recess (29).

2. Apparatus according to claim 1, wherein the roof high voltage line (L) passes through the top space (28) of the isolator body (25).

3. Apparatus according to claim 1 or claim 2, wherein each of the outputs (11) constitutes means for network recognizing whenever a signal is present on said output.
